# EUROPÄISCHE PATENTSCHRIFT

(11) **EP 1 064 708 B1**
(45) Veröffentlichungstag und Bekanntmachung des Hinweises auf die Patenterteilung: **19.09.2001**
(21) Anmeldenummer: 99915603.7
(22) Anmeldetag: 13.03.1999
(51) Int. Cl.: H02B 1/30

(54) **BAUSATZ FÜR EINEN SCHALTSCHRANK**
COMPONENT KIT FOR A SWITCH CABINET
KIT POUR ARMOIRE DE COMMANDE

(30) Priorität: 18.03.1998 DE 19811714
(43) Veröffentlichungstag der Anmeldung: 03.01.2001
(73) Patentinhaber: Rittal-Werk Rudolf Loh GmbH & Co. KG, 35745 Herborn (DE)
(72) Erfinder: NICOLAI, Walter, D-35418 Buseck (DE); BENNER, Rolf, D-35745 Herborn (DE); BESSERER, Horst, D-35745 Herborn (DE); HARTEL, Marc, D-35447 Reiskirchen (DE)
(74) Vertreter: Fleck, Hermann-Josef, Dr.-Ing.
(86) Internationale Anmeldenummer: EP9901666
(87) Internationale Veröffentlichungsnummer: WO9948178

(56) Entgegenhaltungen:
- US-A- 4 461 519

## Beschreibung

Die Erfindung betrifft einen Bausatz für einen Schaltschrank mit einem Rahmengestell, dessen offene Seiten mittels Wandelementen und wenigstens einer Schranktür verkleidbar sind.

Aus der DE 44 39 622 C1 ist ein Schaltschrank bekannt, bei dem das Rahmengestell aus zwölf gleichen Rahmenprofilen und acht Eckverbindern zusammengesetzt ist. Die offenen Seiten des Rahmengestelles können mit drei Wandelementen, einem Deckel und einer Schranktür verschlossen werden. Zur Anbringung der Wandelemente sind in die vertikalen Rahmenprofile und die Eckverbinder Gewindeaufnahmen eingebracht. Hierzu fluchtend können Schraubenaufnahmen der Wandelemente angeordnet werden. Durch die Schraubenaufnahmen können Befestigungsschrauben hindurchgeführt und in die Gewindeaufnahmen eingeschraubt werden.

Bei solchen Schaltschränken ist der verfügbare Einbauraum für die Unterbringung von elektrischen Einbauten festgelegt. Bei einer kompakten Bestückung eines Schaltschrankes bereitet ein nachträgliches Aufrüsten damit Probleme.

Es ist Aufgabe der Erfindung, einen Bausatz für einen Schaltschrank der eingangs erwähnten Art zu schaffen, bei dem auf einfache Weise zusätzlicher Installationsraum verfügbar gemacht werden kann.

Diese Aufgabe der Erfindung wird dadurch gelöst, daß an dem Rahmengestell wahlweise unterschiedliche Wandelemente und/oder Schranktüren anbringbar sind, die unterschiedliche, in Richtung senkrecht der jeweilige Seiten des Rahmengestelles verlaufende Bautiefen aufweisen.

Der erfindungsgemäße Bausatz ermöglicht es, das Volumen des Schaltschrank-Innenraumes zu variieren. Dabei können dann, abhängig von der gewünschten Bestückung, wahlweise eine oder mehrere Seiten des Rahmengestelles erweitert werden. Insbesondere kann der Schaltschrank in Breiten- und Tiefenrichtung hinsichtlich seines verfügbaren Volumens verändert werden.

Nach einer bevorzugten Ausgestaltungsvariante der Erfindung ist es vorgesehen, daß wenigstens eines der Wandelemente eine dem Schaltschrank-Innenraum abgewandte Ausbauchung aufweist, die als Kabelaufnahmeraum ausgebildet ist und der Kabel über Kabeldurchführungen des Wandelementes zuführbar sind, und daß die Kabeldurchführungen in dem, dem Boden und/oder der Oberseite des Schaltschrankes zugeordneten Bereich in das Wandelement eingebracht sind. Dem Kabelaufnahmeraum können damit vom Boden oder der Decke kommende Kabel zugeführt werden. Hier lassen sie sich geordnet unterbringen und dann in die gewünschten Stellen des Schaltschrank-Innenraumes abzweigen.

Dabei kann es vorgesehen sein, daß die Kabeldurchführungen des Wandelementes mittels ausziehbaren Einsätzen oder Deckeln verschließbar sind, so daß diese wahlweise im Bedarfsfall zugänglich gemacht werden können.

Um eine einfache Montage der Wandelemente bewerkstelligen zu können, ist es denkbar, daß diese in eine Schwenklagerung mit horizontaler Schwenkachse einhängbar sind, daß die Wandelemente in eine aufrechte Montageposition schwenkbar sind, und daß die Wandelemente in dieser Montageposition mittels wenigstens eines Befestigungselements an dem Rahmengestell festlegbar sind. Bei dieser Anordnung kann die Anbringung des Wandelementes von einem einzigen Monteur durchgeführt werden. Als Befestigungselemente finden bevorzugt Schnellspanneinrichtungen Verwendung.

Ein erfindungsgemäßer Bausatz ist beispielsweise dadurch gekennzeichnet, daß die Wandelemente eine ebene Wandung aufweisen, die an ihren vertikalen Rändern mit Abwinklungen versehen sind, und daß die Abwinklungen der unterschiedlichen Wandelemente verschiedene Erstreckungen in Richtung senkrecht zu der zugeordneten Seite des Rahmengestelles aufweisen. Mit dieser Maßnahme lassen sich einfach ausgestaltete Wandelemente verwirklichen, die mit geringem Teileaufwand gefertigt werden können.

Wenn es vorgesehen ist, daß das Rahmengestell vier vertikale Rahmenprofile aufweist, die die Seiten des Rahmengestelles bilden, und daß die Wandelemente mit ihren Abwinklungen jeweils an den einander zugewandten Seiten zweier benachbarter vertikaler Rahmenprofile anliegen, dann können die Wandelemente einfach in die dafür vorgesehenen Öffnungen des Rahmengestelles eingesetzt und hierin befestigt werden.

Ähnlich wie bei den Wandelementen können auch die Schranktüren ein ebenes Türblatt aufweisen, das an seinen Ränder mit einer umlaufenden Abkantung versehen ist. Die Abkantungen von verschiedenen Schranktüren weisen dabei unterschiedliche Bautiefen auf.

Es kann auch beispielsweise vorgesehen sein, daß eine der verfügbaren Schranktüren ein Sichtfenster in dem Türblatt einfaßt.

Die Erfindung wird im folgenden anhand eines in den Zeichnungen dargestellten Ausführungsbeispieles näher erläutert. Es zeigen:
- Fig. 1: in perspektivischer Explosionsdarstellung ein Rahmengestell eines Schaltschrankes an das wahlweise unterschiedliche Wandelemente angebracht werden können,
- Fig. 2: das Rahmengestell gem. Fig. 1 in Zusammenstellzeichnung mit zwei Wandelementen,
- Fig. 3: das Rahmengestell gem. den Fig. 1 und 2 in perspektivischer Teildarstellung mit einem angebauten Wandelement und
- Fig. 4: das Rahmengestell gemäß den Fig. 1 und 2 mit drei verschiedenen Schranktüren.

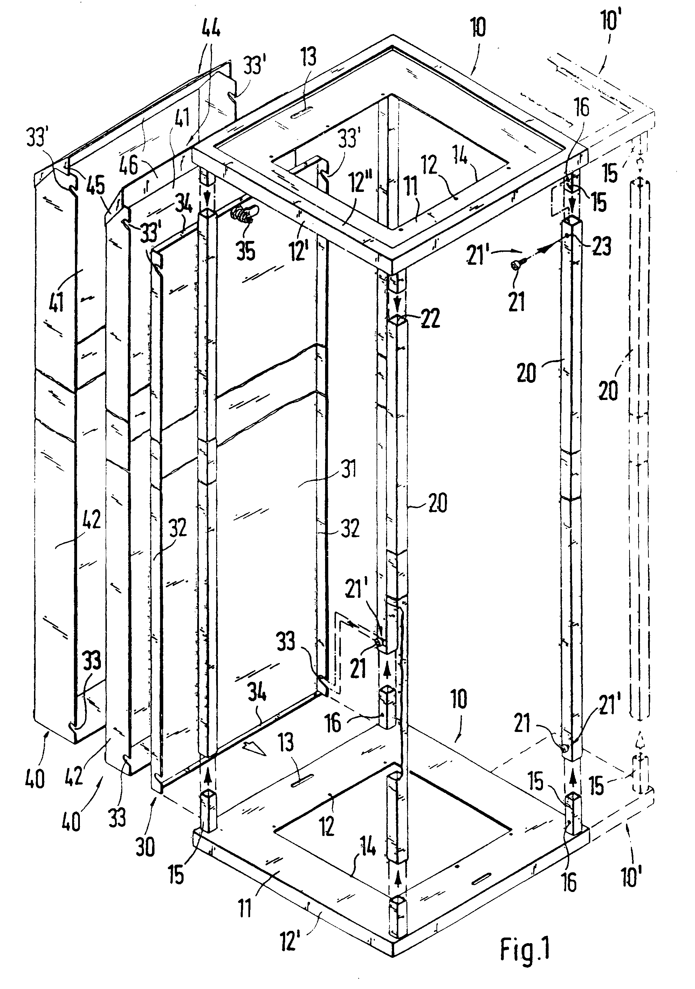

In der Fig. 1 ist ein Rahmengestell für einen Schaltschrank dargestellt, welches eine untere und eine obere Basiseinheit 10 aufweist. Die Basiseinheit 10 ist aus einem flächigem Stahlblechzuschnitt gefertigt. Sie weist einen horizontal ausgerichteten Boden 11 auf, der an seinen Seiten mit abgewinkelten Rändern 12' versehen ist. Die Ränder 12' gehen in Abkantungen 12" über, die parallel zu dem Boden 11 ausgerichtet sind. In den Eckbereichen des Bodens 11 sind Steckansätze 15 angeordnet. Diese können mit der Basiseinheit 10 entweder verschraubt oder verschweißt werden. Die Steckansätze 15 weisen eine Gewindeaufnahme 16 auf, die dem Innenraum des Schaltschrankes zugekehrt ist. Auf die Steckansätze 15 können vertikale Rahmenprofile 20 aufgeschoben werden. Die vertikalen Rahmenprofile 20 sind dabei als Vierkanthohlprofile ausgebildet, deren Innenquerschnitt in etwa dem Außenquerschnitt des Steckansatzes 15 entspricht. Wenn die vertikalen Rahmenprofile 20 auf die Steckansätze 15 aufgeschoben sind, so sind Schraubenaufnahmen 23 der vertikalen Rahmenprofile 20 fluchtend zu den Gewindeaufnahmen 17 der Steckansätze 15 ausgerichtet. In diese Schraubenaufnahmen 23 können Befestigungsschrauben 21' eingesetzt und in die Gewindeaufnahmen 16 eingeschraubt werden. Damit sind die vertikalen Rahmenprofile 20 mit den Basiseinheiten 10 zu dem Rahmengestell fest verbunden. In der Fig. 1 ist in gestrichelter Darstellung die Verwendung von unterschiedlich breiten Basiseinheiten 10, 10' symbolisiert. Bei der Verwendung der verschiedenen Basiseinheiten 10, 10' bleiben die vertikalen Rahmenprofile 20 unverändert.

Die offenen Seiten des Rahmengestelles können mittels Wandelementen 30, 40 und einer, in der Zeichnung nicht dargestellten Tür, verkleidet werden. In der Fig. 1 ist angedeutet, daß unterschiedliche Wandelemente 30, 40 wahlweise an das Rahmengestell angebaut werden können. Beispielsweise kann das Wandelement 30 verwendet werden. Das Wandelement 30 hat eine flächige, vertikal ausgerichtete Wandung 31, die an ihren Rändern mit Abwinklungen 32, 34 versehen ist. Die Abwinklungen 32, 34 weisen in Richtung des Innenraumes des Rahmengestelles. Die beiden vertikalen Abwinklungen 32 sind mit schlitzförmigen Scharnierbolzen-Aufnahmen 33 versehen. Dabei sind die Scharnierbolzen-Aufnahmen 33 schräg aufwärts gerichtet in die Abwinklungen 32 eingeschnitten. Sie weisen ein geöffnetes Schlitzende auf, mittels dessen sie auf den Schraubenkopf der Befestigungsschraube 21' aufgeschoben werden können. Der Schraubenkopf der Befestigungsschraube 21' dient als Scharnierbolzen 21. Das Wandelement 30 kann mit seinen Scharnierbolzen-Aufnahmen 33 auf den Scharnierbolzen 21 aufgeschoben werden, so daß eine Schwenklagerung mit horizontal ausgerichteter Schwenkachse entsteht. Das Wandelement 30 kann dabei im Winkel zur zugeordneten Seite des Rahmengestelles gehalten werden, ohne das es von den Scharnierbolzen 21 abrutscht. Dies wird durch die schräg eingeschnittenen Scharnierbolzen-Aufnahmen 33 ermöglicht. Zur Festlegung des Wandelementes 30 ist ein als Schloß ausgebildetes Befestigungselement 35 vorgesehen. In der eingeklappten Schwenkstellung schlägt das Wandelement 30 an den beiden oberen Befestigungsschrauben 21 an. Hierzu sind die Abwinklungen 32 mit Ausklinkungen 33' versehen, die die Anschläge bilden. In dieser Montageposition kann das Schloß 35 verdreht werden, so daß ein zungenförmiges Schließelement des Schlosses in eine schlitzförmgie Schließaufnahme 13 der oberen Basiseinheit 10 eingreifen kann.

Anstelle des Wandelementes 30 kann auch ein Wandelement 40 an das Rahmengestell angebaut werden, das eine dem Innenraum des Rahmengestelles abgewandte Ausbauchung aufweist. Diese Ausbauchung dient als Kabelkanal. Die Ausbauchung wird dabei von einer seitlichen Wandung 41 und den daran angeschlossenen Abwinklungen 42 gebildet. Im Gegensatz zu den Abwinklungen 32, 34 des Wandelementes 30 weisen die Abwinklungen 42 des Wandelementes 40 eine größere Bautiefe auf. Im oberen, der Basiseinheit zugewandten Bereich ist das Wandelement 40 geöffnet und kann mit einem Deckel 44 verchlossen werden. Der Deckel 44 weist ein oberes Deckelblech 46 auf, an das sich abwärtsgerichtete Seitenteile 45 anschließen. Die Seitenteile 45 übergreifen die Abwinklungen 42, so daß das Deckelblech 46 mit seiner Unterseite auf den Abwinklungen 42 anschlägt. Die Abwinklungen 42 sind in diesem Bereich abgeschrägt, so daß auch das Deckelblech 46 im Winkel zur Horizontalen angeordnet ist. Dies ermöglicht einen verbesserten Wasserablauf. In der Fig. 1 sind zwei Wandelemente 40 dargestellt, die wahlweise an das Rahmengestell angebaut werden können. Diese beiden Wandelemente 40 weisen verschiedene Bautiefen auf. Damit können auch, je nach Bedarf des Anwenders, unterschiedlich große Rangierräume für Kabel zur Verfügung gestellt werden. Die Anbringung der Wandungen 40 erfolgt in gleicher Weise wie die Befestigung des Wandelementes 30. Zunächst werden diese mit Scharnierbolzen-Aufnahmen 33 auf die Scharnierbolzen 21 aufgesetzt. Anchließend lassen sich die Wandelemente 40 in die aufrechte Position bewegen und mittels Befestigungselementen an dem Rahmengestell festlegen. Die Abwinklungen 42 sind wiederum mit den Ausklinkungen 33' versehen, die als Anschläge dienen. Wenn der Schaltschrank in einem feuchtigkeitsgeschützten Innenraum aufgestellt ist, so kann der Deckel 44 abgenommen werden. Über den Deckel 44 können Kabel in den Kabelschacht der Wandung 40 eingeführt werden. Aus dem Kabelschacht lassen sich dann die eingeführten Kabel in den Innenraum des Schaltschrankes abzweigen. Die Kabeleinführung ist auch durch einen von den Basiseinheiten 10, 10' umschlossenen Ausbruch 14 hindurch möglich. Der Ausbruch 14 kann mittels Abdeckplatten verschlossen werden, die an Befestigungsaufnahmen 12, die um den Ausbruch 14 herum angeordnet sind, befestigt werden. Wahlweise lassen sich auch an den Befestigungsaufnahmen 12 Kabeldurchführungen anschrauben.

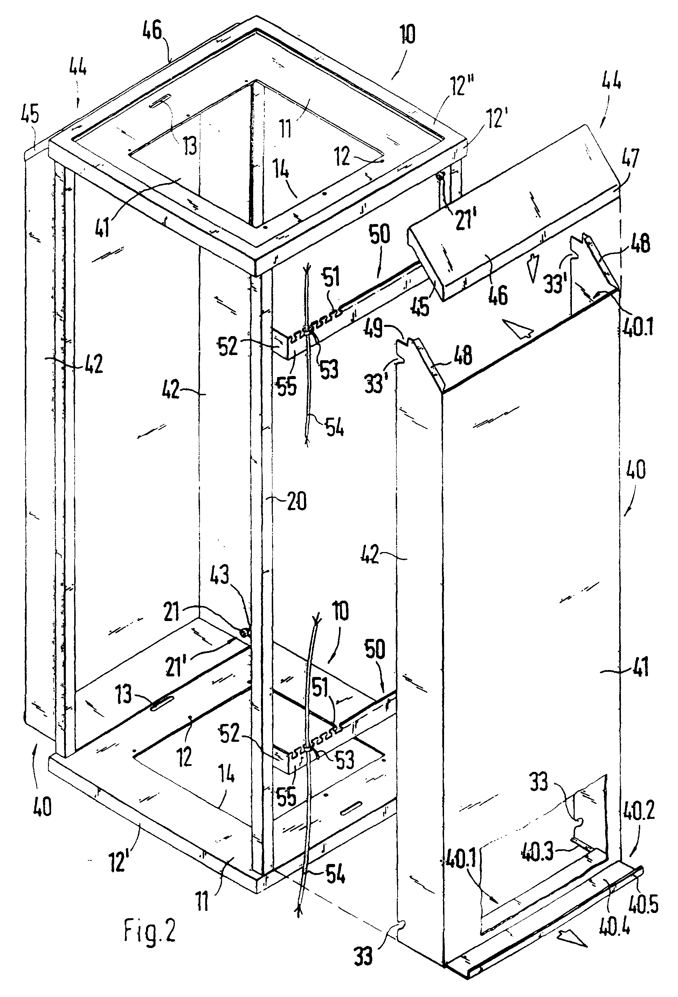

In der Fig. 2 ist die Verwendung von zwei Wandungen 40 gezeigt, die einen Kabelkanal umschließen. Wie sich aus dieser Darstellung erkennen läßt, können an den vertikalen Rahmenprofilen 20 Kabelabfangungen 50 befestigt werden. Die Kabelabfangungen 50 weisen zwei zueinander parallele Schenkel 52 auf, die innenseitig an den vertikalen Rahmenprofilen 20 angeschraubt werden können. Die beiden Schenkel 52 ragen in den von dem Wandelement 40 umschlossenen Kabelraum und tragen einen Halteabschnitt 55. Aus dem Halteabschnitt **55** sind eine Vielzahl von Zungen 51 freigeschnitten. An diesen Zungen 51 können Kabel 54 mittels Kabelbindern 53 befestigt werden. Wie der Fig. 2 weiter entnommen werden kann, sind die Abwinklungen 42 des Wandelementes 40 in ihren oberen Bereichen mit Ausklinkungen 49 versehen. Mit diesen Ausklinkungen 49 umgreift die jeweilige Abwinklung 42 die obere Basiseinheit 10, so daß das Deckelblech 46 des Deckels 44 bündig in die Oberseite der Basiseinheit 10 übergehen kann. Im Anschluß an die Ausklinkungen 49 sind von den Abwinklungen 42 Stützabschnitte 48 abgekantet, auf denen der Deckel 44 aufliegt. Bei aufgesetztem Deckel 44 übergreifen die Seitenteile 45 die Abwinklungen 42. Die Wandung 41 wird von einem Rand 47, der vom Deckelblech 46 abgebogen ist, übergriffen.

Um Kabel auch aus dem Fußboden heraus in den von dem Wandelement 40 umschlossenen Kabelkanal einführen zu können, sind bei den Wandelementen 40 Einsätze 40.2 verwendet werden. Ein solcher Einsatz 40.2 besitzt eine horizontale Verschlußplatte 40.4, von der einstückig ein Griff 40.5 abgekantet ist. Die Verschlußplatte 40.4 kann durch eine Aussparung der Wandung 41 hindurchgeschoben werden. Von den Abwinklungen 42 sind Führung 40.3 abgekantet. Auf diesen Führungen 40.3 kann die Verschlußplatte 40.4 gleiten. Die Einsetzbewegung des Einsatzes 40.2 in das Wandelement 40 wird mittels des Griffes 40.5 begrenzt. Dieser schlägt an der Wandung 41 an. Bei herausgezogenem Einsatz 40.2 wird eine Kabeldurchführung 40.1 freigegeben, durch die Kabel 54 hindurch in den Kabelkanal des Wandelementes 40 eingeführt werden können.

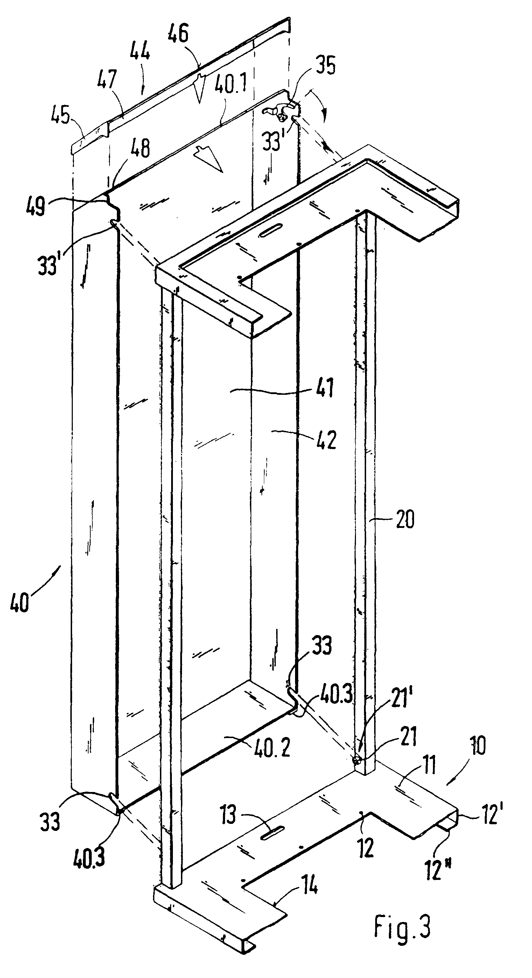

In der Fig. 3 ist die Vorgehensweise zur Befestigung eines Wandelements 40 an dem Rahmengestell näher verdeutlicht. Das Wandelement 40 kann mit seinen schlitzförmigen Scharnierbolzen-Aufnahmen 33 auf die Scharnierbolzen 21 aufgesetzt und anschließend in die vertikale Montageposition gebracht werden. Die abschließende Befestigung des Wandelements 40 erfolgt mit zwei Befestigungselementen 35. Die Befestigungselemente 35 weisen Schließhaken auf, die um eine senkrecht zu den Abwinklungen 42 stehende Drehachse verschwenkbar sind. An den Schließhaken ist ein Griff angekoppelt.

Wenn das Wandelement 40 in seine Montageposition gebracht ist, dann kann der Schließhaken über den Griff verschwenkt werden.

Der Schließhaken hintergreift dann die in der Ausklinkung 33' aufgenommene Befestigungsschraube 21' und verspannt diese. Das Befestigungselement 35 kann, zur Verhinderung von unbefugtem Zuriff, nur von dem Schaltschrank-Innenraum her betätigt werden.

Zur sicheren Festlegung sind an beiden Abwinklungen 42 des Wandelementes 40 Befestigungselemente 35 angebracht.

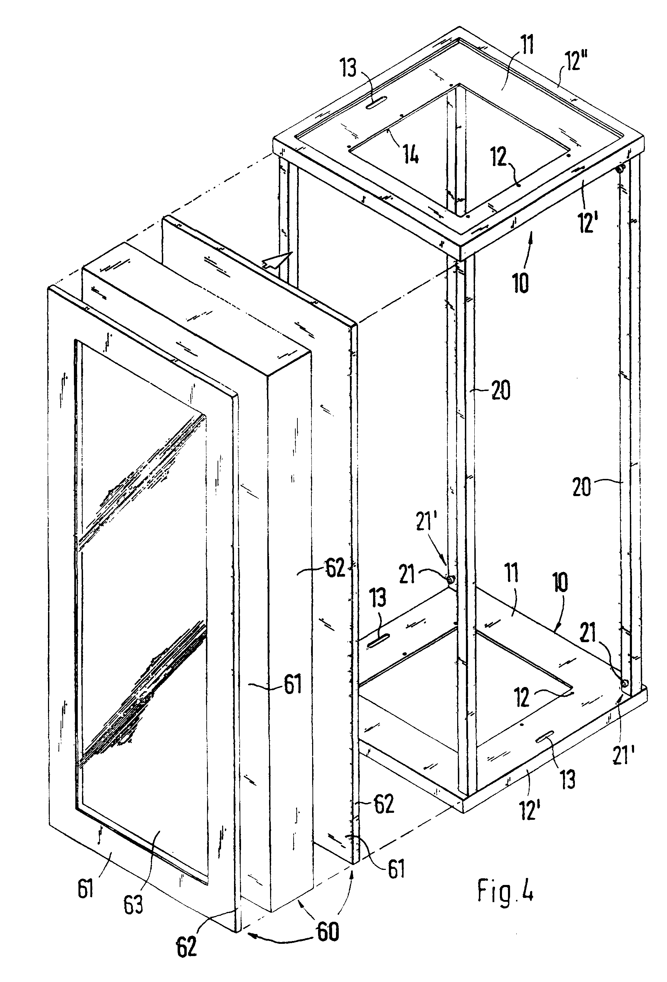

In der Fig. 4 ist die Verwendung von drei verschiedenen Schranktüren 60 gezeigt.

Die Schranktüren 60 weisen ein ebenes Türblatt 61 auf, das an seinen Rändern mit einer umlaufenden Abkantung 62 versehen ist, Die Abkantung 62 kann dabei unterschiedliche Erstreckungen in Richtung senkrecht zum Türblatt 61 aufweisen. Mit so gestalteten Schranktüren 60 kann der verfügbare Bauraum des Schaltschrankes frontseitig erweitert werden.

Um von der Außenseite des Schaltschrankes her Funktionen im Innenraum des Schaltschrankes überwachen zu können, kann bei einer Schranktür 60 ein Sichtfenster 63 in das Türblatt 61 eingebracht sein.

## Patentansprüche

1. Bausatz für einen Schaltschrank mit einem Rahmengestell, dessen offene Seiten mittels Wandelementen (30, 40) und wenigstens einer Schranktür (60) verkleidbar sind,
**dadurch gekennzeichnet,**
**daß** an dem Rahmengestell wahlweise unterschiedliche Wandelemente (30, 40) und/oder Schranktüren (60) anbringbar sind, die unterschiedliche, in Richtung senkrecht der jeweilige Seiten des Rahmengestelles verlaufende Bautiefen aufweisen.

2. Bausatz nach Anspruch 1,
**dadurch gekennzeichnet**,
**daß** wenigstens eines der Wandelemente (40) eine, dem Schaltschrank-Innenraum abgewandte Ausbauchung aufweist, die als Kabelaufnahmeraum ausgebildet ist und der Kabel (54) über Kabeldurchführungen (40.1) des Wandelementes (40) zuführbar sind, und
daß die Kabeldurchführungen (40.1) in dem, dem Boden und/oder der Oberseite des Schaltschrankes zugeordneten Bereich in das Wandelement (40) eingebracht sind.

3. Bausatz nach Anspruch 3,
**dadurch gekennzeichnet,**
**daß** die Kabeldurchführungen (40.1 ) des Wandelementes (40) mittels ausziehbaren Einsätzen (40.2) oder Deckeln (44) verschließbar sind.

4. Bausatz nach einem der Ansprüche 1 bis 3,
**dadurch gekennzeichnet**,
**daß** die Wandelemente (40) in eine Schwenklagerung mit horizontaler Schwenkachse einhängbar sind,
**daß** die Wandelemente (40) in eine aufrechte Montageposition schwenkbar sind, und
**daß** die Wandelemente (40) in dieser Montageposition mittels wenigstens eines Befestigungselementes (35) an dem Rahmengestell festlegbar sind.

5. Bausatz nach einem der Ansprüche 1 bis 4,
**dadurch gekennzeichnet**,
**daß** die Wandelemente (**40**) eine ebene Wandung (**41**) aufweisen, die an ihren vertikalen Rändern mit Abwinklungen (**42**) versehen sind, und
**daß** die Abwinklungen (42) der unterschiedlichen Wandelemente (42) verschiedene Erstreckungen in Richtung senkrecht zu der zugeordneten Seite des Rahmengestelles aufweisen.

6. Bausatz nach Anspruch 5,
**dadurch gekennzeichnet**,
**daß** das Rahmengestell vier vertikale Rahmenprofile (20) aufweist, die die Seiten des Rahmengestelles bilden, und
daß die Wandelemente (40) mit ihren Abwinklungen (42) jeweils an den einander zugewandten Seiten zweier benachbarter vertikaler Rahmenprofile (20) anliegen.

7. Bausatz nach einem der Ansprüche 1 bis 6,
**dadurch gekennzeichnet**,
daß die Schranktür (**60**) ein ebenes Türblatt (**61**) aufweist, das an seinen Rändern mit einer umlaufenden Abkantung (**62**) versehen ist, und
daß die Abkantung (62) bei verschiedenen Schranktüren (**60**) unterschiedliche Bautiefen festlegen.

8. Bausatz nach einem der Ansprüche 1 bis 7,
**dadurch gekennzeichnet,**
**daß** bei einer der Schranktüren (60) ein Sichtfenster (63) in dem Türblatt (61) eingefaßt ist.

## Claims

1. Construction kit for a switch cabinet with a framework, of which the open sides can be panelled by means of wall elements (30, 40) and at least one cabinet door (60), **characterized in that** different wall elements (30, 40) and/or cabinet doors (60) may optionally be fitted on the framework, said wall elements and/or cabinet doors having different depths running in the direction perpendicular to the respective sides of the framework.

2. Construction kit according to Claim 1, **characterized in that** at least one of the wall elements (40) has a convexity which is directed away from the switch-cabinet interior, is designed as a cable-accommodating space and to which cables (54) can be fed via cable lead-throughs (40.1) in the wall element (40), and in that the cable lead-throughs (40.1) are introduced into the wall element (40) in the region assigned to the base and/or the top side of the switch cabinet.

3. Construction kit according to Claim 2, **characterized in that** the cable lead-throughs (40.1) in the wall element (40) can be closed off by means of pull-out inserts (40.2) or covers (44).

4. Construction kit according to one of Claims 1 to 3, **characterized in that** the wall elements (40) can be fitted in a pivot mounting with a horizontal pivot axis, in that the wall elements (40) can be pivoted into an upright installation position, and in that the wall elements (40), in this installation position, can be secured on the framework by means of at least one fastening element (35).

5. Construction kit according to one of Claims 1 to 4, **characterized in that** the wall elements (40) have a planar wall (41) which is provided with angled portions (42) on its vertical borders, and in that the angled portions (42) of the different wall elements (40) have different extents in the direction perpendicular to the associated side of the framework.

6. Construction kit according to Claim 5, **characterized in that** the framework has four vertical frame profiles (20), which form the sides of the framework, and in that the wall elements (40) butt, by way of their angled portions (42), in each case against the mutually facing sides of two adjacent vertical frame profiles (20).

7. Construction kit according to one of Claims 1 to 6, **characterized in that** the cabinet door (60) has a planar door leaf (61) which is provided with a peripheral bent portion (62) on its borders, and in that the bent portion (62), in different cabinet doors (60), defines different depths.

8. Construction kit according to one of Claims 1 to 7, **characterized in that**, in one of the cabinet doors (60), a viewing window (63) is enclosed in the door leaf (61).

## Revendications

1. Module pour le montage d'une armoire de commutation, avec un bâti d'encadrement dont les côtés ouverts peuvent être recouverts par des éléments de paroi (30, 40) et avec au moins une porte d'armoire (60), **caractérisé en ce que** différents éléments de paroi (30, 40) et/ou portes d'armoire (60) peuvent être installés au choix sur le bâti d'encadrement et présentent différentes profondeurs de montage dans la direction perpendiculaire à chaque côté du bâti d'encadrement.

2. Module selon la revendication 1, **caractérisé en ce qu'**au moins l'un des éléments de paroi (40) présente un emboutissage non tourné vers l'espace intérieur de l'armoire de commutation, qui est configuré comme espace de réception de câbles et dans lequel des câbles (54) peuvent être amenés par des passages de câble (40.1) de l'élément de paroi (40), et en ce que les passages de câble (40.1) sont installés dans l'élément de paroi (40) dans la zone associée au plancher et/ou au côté supérieur de l'armoire de commutation.

3. Module selon la revendication 1, **caractérisé en ce que** les passages de câble (40.1) de l'élément de paroi (40) peuvent être fermés au moyen de garnitures (40.2) ou de couvercles (44) amovibles.

4. Module selon l'une des revendications 1 à 3, **caractérisé en ce que** les éléments de paroi (40) peuvent être accrochés dans un palier de pivotement à axe horizontal de pivotement, en ce que les éléments de paroi (40) peuvent pivoter dans une position de montage relevée et en ce que dans cette position de montage, les éléments de paroi (40) peuvent être fixés sur le bâti d'encadrement au moyen d'au moins un élément de fixation (35).

5. Module selon l'une des revendications 1 à 4, **caractérisé en ce que** les éléments de paroi (40) présentent une paroi plane (41) qui est dotée de rabats (42) sur ses bords verticaux, et en ce que les rabats (42) des différents éléments de paroi (40) présentent différentes extensions dans la direction perpendiculaire au côté associé du bâti d'encadrement.

6. Module selon la revendication 5, **caractérisé en ce que** le bâti d'encadrement présente quatre profilés verticaux d'encadrement (20) qui forment les côtés du bâti d'encadrement, et en ce que chacun des éléments de paroi (40) repose par ses rabats (42) contre les côtés tournés l'un vers l'autre de deux profilés verticaux d'encadrement (20) voisins.

7. Module selon l'une des revendications 1 à 6, **caractérisé en ce que** la porte d'armoire (60) présente une feuille de porte (61) plane qui est dotée d'un repli périphérique (62) sur ses bords, et en ce que les replis (62) définissent différentes profondeurs de montage pour différentes portes d'armoire (60).

8. Module selon l'une des revendications 1 à 7, **caractérisé en ce qu'**une fenêtre d'observation (63) est incluse dans la feuille de porte (61) de l'une des portes d'armoire (60).
